# EUROPEAN PATENT APPLICATION

(11) **EP 4 712 349 A2**
(43) Date of publication of application: **18.03.2026**
(21) Application number: 26154112.2
(22) Date of filing: 26.01.2026
(51) Int. Cl.: H03K 5/15, G06F 1/10

(54) **COMPUTING ARRAY INTEGRATED CIRCUITS AND CHIPS**

(30) Priority: 27.06.2025 CN 202510887508
(71) Applicant: Beijing Horizon Information Technology Co., Ltd., Beijing 100094 (CN)
(72) Inventor: YUAN, Jiawei, Beijing 100094 (CN); HU, Ruijun, Beijing 100094 (CN); HOU, Mingyang, Beijing 100094 (CN); CAO, Qingfu, Beijing 100094 (CN)
(74) Representative: Müller-Boré & Partner Patentanwälte PartG mbB

(57) **Abstract**

Embodiments of the present disclosure provide a computing array integrated circuit and a chip, wherein the computing array integrated circuit comprises: at least one clock buffer for delaying an input clock signal for a specified duration and outputting the delayed clock signal, the delayed clock signals output by different clock buffers not being synchronized; a plurality of computing array sub-circuits, each of the clock buffers being coupled to at least one computing array sub-circuit in the plurality of computing array sub-circuits, each of the computing array sub-circuits acquiring the delayed clock signal output by the respective corresponding clock buffer. Embodiments of the present disclosure may reduce the instantaneous dynamic power consumption pressure and improve the safety of the circuit.

## Description

### FIELD

The present disclosure relates to integrated circuit technologies, and particularly to computing array integrated circuits and chips.

### BACKGROUND

In an integrated circuit comprising a hardware circuit with an accelerated processing function, the hardware circuit for an accelerated processing procedure typically comprises a large-scale multiply-add circuit, wherein the multiply-add circuit comprises a large number of transistors; during the operation of the circuit, when the state of a clock signal changes, a large number of transistors are caused to switch, and meanwhile a jump of a combinational logic circuit is caused, and a very large current is generated on the whole circuit in a short period of time, which is apt to cause an excessive dynamic IR DROP. The dynamic IR DROP refers to a voltage drop phenomenon of a power supply caused by a current fluctuation when a circuit switch switches in the integrated circuit. This phenomenon occurs mainly on a triggering edge of the clock signal. The dynamic IR DROP results in adverse impacts on the behaviors of standard cells (e.g., a selector MUX, a logic gate, etc.) in the circuit, causes uncertainty to the circuit and affects the safety of the circuit.

### SUMMARY

Embodiments of the present disclosure provide a computing array integrated circuit and a chip to reduce the instantaneous dynamic power consumption pressure and improve the safety of the circuit.

In a first aspect of embodiments of the present disclosure, there is provided a computing array integrated circuit comprising: at least one clock buffer for delaying an input clock signal for a specified duration and outputting the delayed clock signal, the delayed clock signals output by different clock buffers not being synchronized; a plurality of computing array sub-circuits, each of the clock buffers being coupled to at least one computing array sub-circuit in the plurality of computing array sub-circuits, each of the computing array sub-circuits acquiring the delayed clock signal output by the respective corresponding clock buffer.

In a second aspect of embodiments of the present disclosure, there is provided a chip comprising: the computing array integrated circuit as described in any of the above embodiments.

According to the computing array integrated circuit and the chip provided in the above embodiments of present embodiment, at least one clock buffer is provided in the computing array integrated circuit, each clock buffer may delay the input clock signal for a specified duration and then output the delayed clock signal, and each clock buffer is coupled to at least one computing array sub-circuit in the plurality of computing array sub-circuits, so that each computing array sub-circuit can acquire the delayed clock signal output by the respective corresponding clock buffer. Since the delayed clock signals output by different clock buffers are not synchronous, the clock signals acquired by at least a portion of computing array sub-circuits in the plurality of computing array sub-circuits of the integrated circuit are not synchronized with the clock signals acquired by other computing array sub-circuits, so that the transistors in the computing array integrated circuit switch at different times, thereby preventing a large number of transistors in the plurality of computing array sub-circuits from switching at the same time, thereby reducing the current generated by the overall circuit in a short time, reducing the dynamic IR DROP of the circuit, avoiding an excessive IR DROP, and ensuring the safety of the circuit.

### BRIEF DESCRIPTION OF THE DRAWINGS

FIG. 1 is an exemplary application scenario of a computing array integrated circuit according to the present disclosure;
FIG. 2 is a schematic diagram of a computing array integrated circuit according to an exemplary embodiment of the present disclosure;
FIG. 3 is a schematic diagram of a computing array integrated circuit according to another exemplary embodiment of the present disclosure;
FIG. 4 is a schematic diagram of a computing array integrated circuit according to yet another exemplary embodiment of the present disclosure;
FIG. 5 is a schematic diagram of a computing array integrated circuit according to a further exemplary embodiment of the present disclosure;
FIG. 6 is a schematic diagram of a computing array integrated circuit according to yet another exemplary embodiment of the present disclosure;
FIG. 7 is a schematic diagram of a computing array integrated circuit according to yet another exemplary embodiment of the present disclosure;
FIG. 8 is a schematic diagram of a computing array integrated circuit according to yet another exemplary embodiment of the present disclosure;
FIG. 9 is a schematic diagram of a computing array integrated circuit according to yet another exemplary embodiment of the present disclosure;
FIG. 10 is a schematic diagram of a computing array integrated circuit according to a further exemplary embodiment of the present disclosure;
FIG. 11 is a schematic diagram of a computing array integrated circuit according to yet another exemplary embodiment of the present disclosure;
FIG. 12 is a schematic diagram of a computing array integrated circuit according to a further exemplary embodiment of the present disclosure;
FIG. 13 is a schematic diagram of a computing array integrated circuit according to yet another exemplary embodiment of the present disclosure;
FIG. 14 is a schematic diagram of clock signals according to an exemplary embodiment of the present disclosure;
FIG. 15 is a schematic diagram of a chip according to an exemplary embodiment of the present disclosure;
FIG. 16 is a block diagram of an electronic device according to an embodiment of the present disclosure.

### DETAILED DESCRIPTION OF EMBODIMENTS

To illustrate the present disclosure, exemplary embodiments according to the present disclosure will be described in detail with reference to the accompanying drawings. Obviously, the described embodiments are only partial embodiments, rather than all embodiments of the present disclosure. It is to be understood that the present disclosure is not limited to the exemplary embodiments.

It should be noted that unless otherwise specified, the scope of the present disclosure is not limited to relative arrangement, numeric expressions, and numerical values of components and steps described in these embodiments.

### Overview of the Present Disclosure

During the implementation of the present disclosure, the Inventor discovers that in an integrated circuit comprising a hardware circuit with an accelerated processing function, the hardware circuit for an accelerated processing procedure typically comprises a large-scale multiply-add circuit, wherein the multiply-add circuit comprises a large number of transistors; during the operation of the circuit, when the state of a clock signal changes, i.e., at a clock edge, the large number of transistors are caused to switch, and meanwhile a jump of a combinational logic circuit in the integrated circuit is caused. The combinational logic circuit comprises one or more standard cells. The standard cells for example may comprise a selector, a comparator, an AND gate; an OR gate, a NOT gate, etc. A large number of standard cells in the combinational logic circuit work simultaneously in a short period of time, resulting in an excessive instantaneous power consumption. In the short period of time, a very large current will be generated on the whole circuit, imposes an excessive pressure on the power supply and is prone to cause an excessive IR DROP. The dynamic IR DROP refers to a voltage drop phenomenon of the power supply caused by a current fluctuation when the circuit switch switches in the integrated circuit. This phenomenon occurs mainly on a triggering edge of the clock signal. The dynamic IR DROP results in adverse impacts on the behaviors of standard cells in the circuit, causes uncertainty to the circuit and affects the safety of the circuit.

### Exemplary Overview

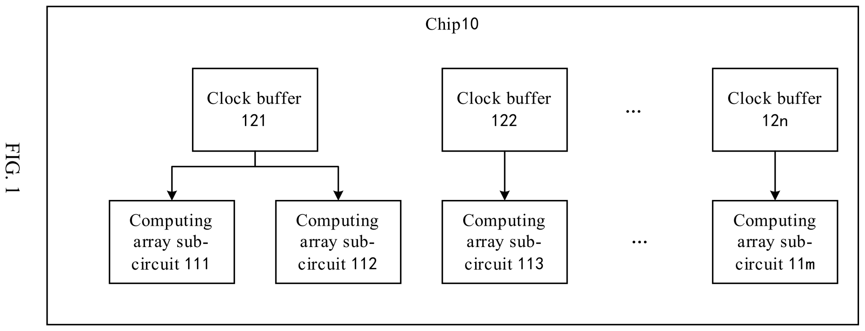

FIG. 1 is an exemplary application scenario of a computing array integrated circuit according to the present disclosure. As shown in FIG. 1, the computing array integrated circuit in a chip 10 may comprise m (m is an integer greater than 1) computing array sub-circuits, such as a computing array sub-circuit 111, a computing array sub-circuit 112, a computing array sub-circuit 113, . . ., and a computing array sub-circuit 11m. The computing array integrated circuit may be referred to as an integrated circuit, an overall circuit, or a circuit. Each computing array sub-circuit is a sub-circuit having the same or similar function. For example, the computing array sub-circuits may comprise one or more of a sub-circuit for image processing acceleration (i.e., an image processing accelerator), a sub-circuit for neural network acceleration (i.e., a neural network accelerator), and other types of accelerators. Alternatively, the computing array sub-circuits may be the image processing accelerator, the neural network accelerator and a smaller-granularity computing array cell among other types of accelerators, such as a computing array cell for a convolution operation, a computing array cell for a matrix multiplication operation, etc. The specific computing array sub-circuit is not limited herein. Any two computing array sub-circuits may be independent of each other or may have a certain data dependency relationship therebetween. With the computing array integrated circuit according to an embodiment of the present disclosure being used, at least one clock buffer, such as a clock buffer 121, a clock buffer 122, ..., and a clock buffer 12n, where n is a positive integer, may be provided on the basis of a plurality of computing array sub-circuits, i.e., the computing array integrated circuit (or chip) may comprise at least one clock buffer and a plurality of computing array sub-circuits. The clock buffer 12i is used for delaying an input clock signal for a specified duration and then outputting a delayed clock signal, where i=1, 2, . . ., or n, and the delayed clock signals output by different clock buffers are not synchronized; each clock buffer 12i is coupled to at least one computing array sub-circuit in the plurality of computing array sub-circuits, and each computing array sub-circuit 11j obtains the delayed clock signal output by the respective corresponding clock buffer, where j=1, 2, ..., or m. Since the delayed clock signals output by different clock buffers are not synchronized, the clock signals acquired by at least a portion of computing array sub-circuits in the plurality of computing array sub-circuits in the computing array integrated circuit are not synchronized with the clock signals acquired by other computing array sub-circuits, for example, the clock signal acquired by the computing array sub-circuit 112 is not synchronized with that acquired by the computing array sub-circuit 113 in the figure, so that the transistors in the computing array integrated circuit switch at different times, thereby preventing a large number of transistors in the plurality of computing array sub-circuits from switching at the same time, thereby reducing the current generated by the overall circuit in a short time, reducing the dynamic IR DROP of the circuit, avoiding an excessive IR DROP, and ensuring the safety of the circuit.

### Exemplary Circuit or Device

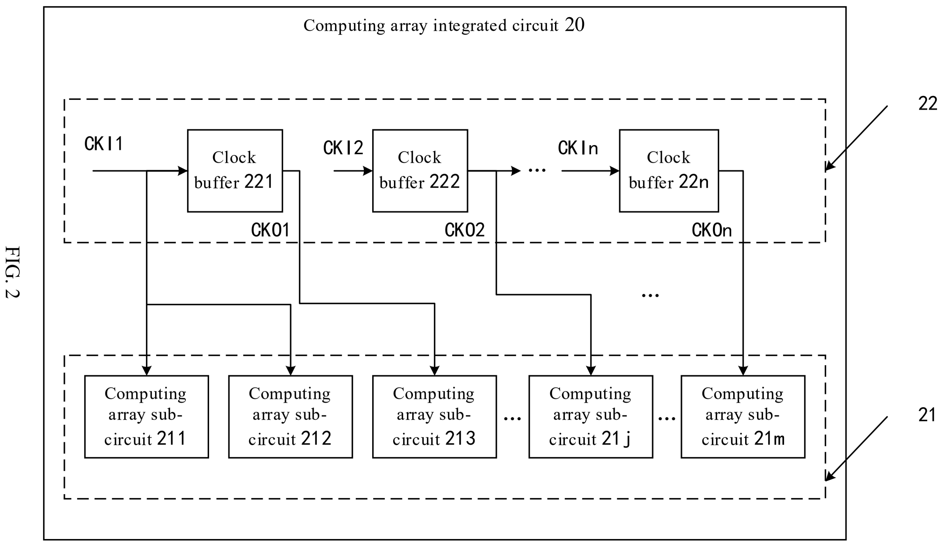

FIG. 2 is a schematic diagram of a computing array integrated circuit according to an exemplary embodiment of the present disclosure. The present embodiment may be applied to an electronic device or a chip (or called a system-on-chip). The electronic device is for example a vehicle-mounted computing platform (or called a vehicle-mounted terminal, a vehicle-mounted platform), a mobile phone, a tablet, etc. The chip is for example an intelligent driving chip, an intelligent cockpit chip etc., and a chip on other terminal device such as a mobile phone, a tablet etc. As shown in FIG. 2, the computing array integrated circuit 20 of the embodiment of the present disclosure may comprise: a plurality of computing array sub-circuits 21, and at least one clock buffer 22. For example, in FIG. 2, the plurality of computing array sub-circuits 21 comprises a computing array sub-circuit 211, a computing array sub-circuit 212, ..., and a computing array sub-circuit 21m, m being an integer greater than 1. The at least one clock buffer 22 comprises a clock buffer 221, a clock buffer 222, ... , and a clock buffer 22n, n being a positive integer.

The clock buffer 22i is used for delaying an input clock signal CKIi for a specified duration and then outputting a delayed clock signal CKOi, where i=1, 2, ..., or n. The delayed clock signals output by different clock buffers are not synchronized; each clock buffer 22i is coupled to at least one computing array sub-circuit in the plurality of computing array sub-circuits, and each computing array sub-circuit 21j acquires the delayed clock signal output by the respective corresponding clock buffer, where j=1, 2, ..., or m.

Each computing array sub-circuit 21j is a sub-circuit having the same or similar function, where j=1, 2, ..., or m. For example, the computing array sub-circuits may comprise one or more of a sub-circuit for image processing acceleration (i.e., an image processing accelerator), a sub-circuit for neural network acceleration (i.e., a neural network accelerator), and other types of accelerators. Alternatively, the computing array sub-circuit may be the image processing accelerator, the neural network accelerator and a smaller-granularity computing array cell among other types of accelerators, such as a computing array cell for a convolution operation, a computing array cell for a matrix multiplication operation, etc. These computing array sub-circuits are typically implemented based on a multiply-add array, and thus have the same or similar function. The specific computing array sub-circuits are not limited herein. The clock buffer (or called a delay buffer) 22i is a device (or a sub-circuit) having a function of delaying the clock signal. Optionally, the clock buffer 22i may also have the function of shaping the clock signal to eliminate distortion caused by line attenuation or interference to ensure the validity of the clock signal. The delayed clock signals output by different clock buffers are not synchronized, which means that the triggering edges of the delayed clock signals output by different clock buffers are not at the same time, for example, CKO1 jumps from a low level (or 0) to a high level (or 1) at time t1, CKO2 jumps from a low level to a high level at time t2, and the cycle of CKO1 is the same as that of CKO2, but CKO2 has a certain delay relative to CKO1. The specified duration is a duration set for the clock buffer to delay the input clock signal, and may be set according to the power consumption requirement of the computing array integrated circuit. The specific specified duration is not limited herein.

In some alternative embodiments, the number m of the computing array sub-circuits may be determined based on actual application requirements. For example, m may be 2, 3, 4, . . .

In some alternative embodiments, the number n of clock buffers may be set according to the requirements for dynamic power consumption in an actual application. For example, n may be 1, 2, 3, ..., and n is less than or equal to m.

In some alternative embodiments, the delayed clock signals output by different clock buffers may be made not synchronized in any control manner, i.e., CKO1, CK02, . . ., and CKOn may be made not synchronized. For example, CKO1, CKO2, ..., and CKOn may be made not synchronized in a way that the clock buffers are connected in series, or CKO1, CKO2, ..., and CKOn are made not synchronized in a way that the clock buffers are connected in parallel and the clock buffers are delayed for different specified durations. The specific control manner is not limited herein.

In some alternative embodiments, coupling refers to the transfer of energy or signals between circuits through any medium, and comprises direct electrical connection, indirect electrical connection, non-contact coupling, etc. Each clock buffer may be coupled to at least one computing array sub-circuit in the plurality of computing array sub-circuit, for example, in the figure the clock buffer 221 may be coupled to the computing array sub-circuit 213, the clock buffer 222 may be coupled to the computing array sub-circuit 214 to the computing array sub-circuit 21j, etc. The number of the computing array sub-circuits to which each clock buffer is coupled may be set as actually needed, for example, the number of the computing array sub-circuits to which each clock buffer is coupled may be determined according to a circuit power consumption balancing principle. This is not limited to the coupling relationship in FIG. 2.

In some alternative embodiments, CKI1 may serve as a clock signal for partial computing array sub-circuits, such as the computing array sub-circuit 211 and the computing array sub-circuit 212 in the figure. Alternatively, in a case where the number of clock buffers is plural, CKI1 may only serve as an input to the clock buffer 221. It is not limited to the coupling relationship in FIG. 2.

In some alternative embodiments, CKI1, CKI2, ..., and CKIn may be set according to the coupling situations of the clock buffers. For example, if the clock buffers are coupled in parallel, CKI1, CKI2, ..., CKIn may be the same clock signal, e.g., they all are CKI1. If the clock buffers are coupled in series, CKIi=CKOi-1.

In some alternative embodiments, in a case where only one clock buffer is included, as exemplified by the clock buffer 221 in the figure, the delayed clock signal CKO1 output by the clock buffer 221 is not synchronized with the clock signal CKI1 input to the clock buffer, the clock buffer 221 is coupled to a portion of computing array sub-circuits of the plurality of computing array sub-circuits, and another portion of computing array sub-circuit may be coupled to a clock signal transmitter outputting CKI1, to acquire CKI1, thereby ensuring that at least a portion of computing array sub-circuits in the plurality of computing array sub-circuits acquire clock signals that are not synchronized with the clock signals acquired by another portion of computing array sub-circuits in the plurality of computing array sub-circuits.

In some alternative embodiments, the specified duration of the delay of each clock buffer may be set according to series connection or parallel connection of each clock buffer, as well as the clock cycle of the clock signal. A setting principle is ensuring that the delay duration of the delayed clock signal output by each clock buffer is within one clock cycle of the clock signal as compared with an undelayed clock signal, to prevent the cross-cycle switching of the transistors from affecting the normal operation of the circuit during the operation of the computing array integrated circuit.

According to the computing array integrated circuit provided in the present embodiment, at least one clock buffer is provided in the computing array integrated circuit, each clock buffer may delay the input clock signal for a specified duration and then output the delayed clock signal, and each clock buffer is coupled to at least one computing array sub-circuit in the plurality of computing array sub-circuits, so that each computing array sub-circuit can acquire the delayed clock signal output by the respective corresponding clock buffer. Since the delayed clock signals output by different clock buffers are not synchronous, the clock signals acquired by at least a portion of computing array sub-circuits in the plurality of computing array sub-circuits of the integrated circuit are not synchronized with the clock signals acquired by other computing array sub-circuits, so that the transistors in the computing array integrated circuit switch at different times, thereby preventing a large number of transistors in the plurality of computing array sub-circuits from switching at the same time, thereby reducing the current generated by the overall circuit in a short time, reducing the dynamic IR DROP of the circuit, avoiding an excessive IR DROP, and ensuring the safety of the circuit.

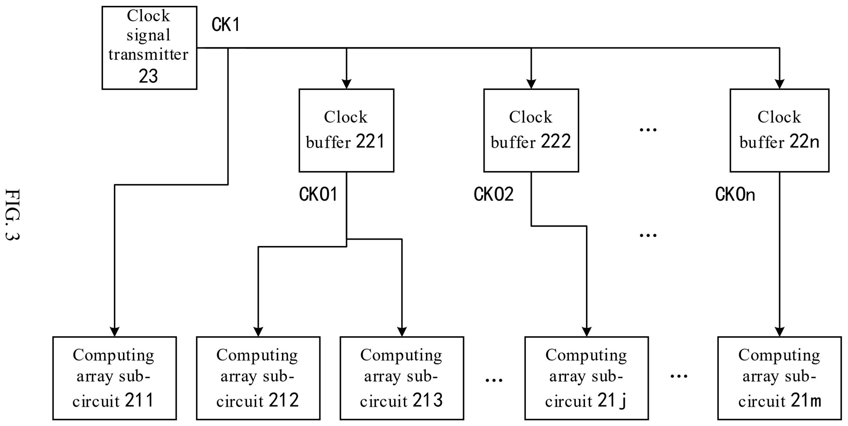

FIG. 3 is a schematic diagram of a computing array integrated circuit according to another exemplary embodiment of the present disclosure.

In some alternative embodiments, based on the embodiment shown in FIG. 2 described above, as shown in FIG. 3, at least one clock buffer comprises a plurality of clock buffers, and the computing array integrated circuit 20 according to the embodiment of the present disclosure further comprises: a clock signal transmitter 23.

The clock signal transmitter 23 is coupled to each clock buffer and used to output the first clock signal CK1.

Any clock buffer 22i in the plurality of clock buffers is used to delay the input first clock signal CK1 for a specified duration and then output the delayed clock signal CKOi, values of specified durations of the delays by different clock buffers being different.

The clock signal transmitter 23 may be a clock source or a clock divider in the computing array integrated circuit 20, or the clock signal transmitter 23 may be a clock buffer coupled to a clock source external to the computing array integrated circuit 20. The specific situation is not limited herein.

In some alternative embodiments, as shown in FIG. 3, the clock buffers are connected in parallel, the input clock signal to each clock buffer is CK1, and the delayed clock signals output by the clock buffers are not synchronized by delaying the CK1 for different specified durations. The value of the specified duration of the delay by each clock buffer may be set according to the clock cycle of the CK1. For example, if the clock cycle of the first clock signal is T, and the number of clock buffers is n, the value of the delay duration of the clock buffer 221 may be T/n, the value of the delay duration of the clock buffer 222 may be 2*T/n, ..., and the value of the delay duration of the clock buffer 22n is T. This is only an example. In practical application, the value of the specified duration of the delay by each clock buffer 22i is not limited to i*T/n, and may be, for example, a value with an unequal interval, and is not specifically limited.

In some alternative embodiments, the clock signal transmitter 23 is also coupled to at least one computing array sub-circuit. For example, in FIG. 3, the clock signal transmitter 23 is coupled to the computing array sub-circuit 211, such that the computing array sub-circuit 211 acquires the first clock signal CK1 output by the clock signal transmitter 23, and CK1 is not synchronized with each CKOi. Therefore, the transistors of the computing array sub-circuit to which the clock signal transmitter 23 is coupled and of the computing array sub-circuit to which each clock buffer is coupled switch at different times, thereby reducing the number of clock buffers.

In the embodiment of the present disclosure, by connecting the plurality of clock buffers in parallel and controlling the value of the specified duration of the delay by each clock buffer to be different, it is possible to realize that the delayed clock signals output by the clock buffers are not synchronous, ensure that the transistors of the plurality of computing array sub-circuits in the computing array integrated circuit may switch at a plurality of dispersed times, improves the power consumption balance, and effectively preventing a large number of transistors of the plurality of computing array sub-circuits from switching at the same time, thereby reducing the current generated by the overall circuit in a short time, reducing the dynamic IR DROP of the circuit, avoiding the excessive IR DROP, and ensuring the safety of the circuit.

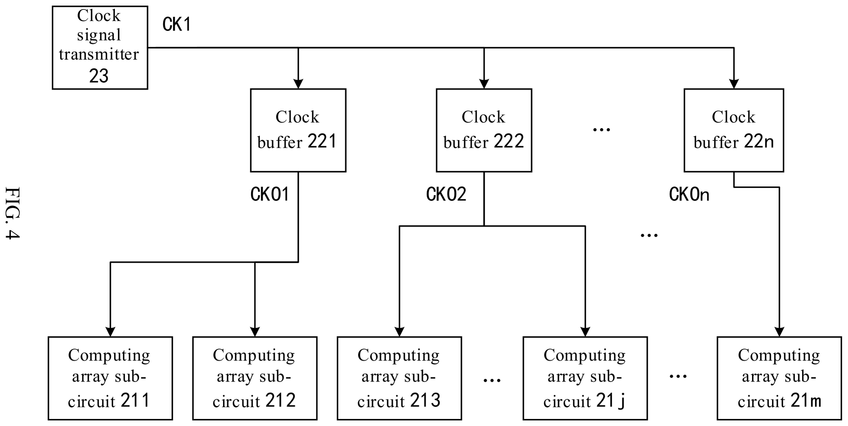

In some alternative embodiments, FIG. 4 is a schematic diagram of a computing array integrated circuit according to yet another exemplary embodiment of the present disclosure. As shown in FIG. 4, based on the embodiment shown in FIG. 3, the clock signal transmitter 23 may not be coupled to the computing array sub-circuit. Each computing array sub-circuit acquires the delayed clock signal output by the respective corresponding clock buffer, thereby ensuring that a large number of transistors of the plurality of computing array sub-circuits switch at a plurality of times, and improving the power consumption balance.

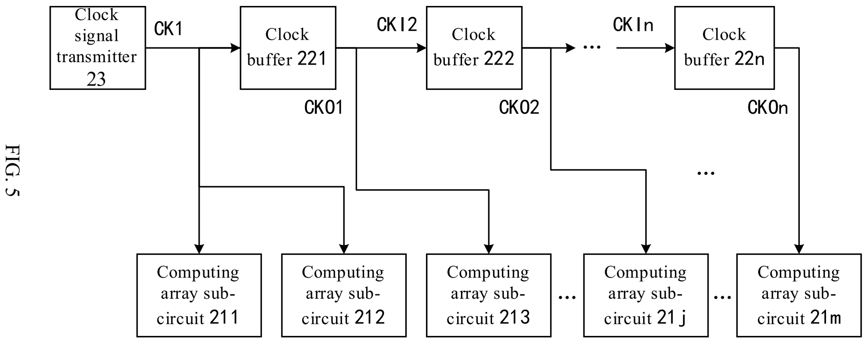

FIG. 5 is a schematic diagram of a computing array integrated circuit according to a further exemplary embodiment of the present disclosure.

In some alternative embodiments, based on any of the embodiments described above, as shown in FIG. 5, the computing array integrated circuit according to the embodiment of the present disclosure further comprises: the clock signal transmitter 23.

The clock signal transmitter 23 is coupled to a preset clock buffer and used to output the first clock signal CK1.

In a case where the at least one clock buffer comprises only one clock buffer, the clock buffer is used to delay the input first clock signal CK1 for a specified duration and output the delayed clock signal, the clock buffer is coupled to the first computing array sub-circuit in the plurality of computing array sub-circuits, the clock signal transmitter 23 is coupled to the second computing array sub-circuit in the plurality of computing array sub-circuits, and the second computing array sub-circuit is a computing array sub-circuit in the plurality of computing array sub-circuits other than the first computing array sub-circuit.

Reference may be made to the aforementioned embodiment for the clock signal transmitter 23. Detailed description thereof will not be presented any longer here. The preset clock buffer is a clock buffer at a preset position in at least one clock buffer. As shown in FIG. 5, the preset clock buffer is the clock buffer 221. In a case where the at least one clock buffer comprises only one clock buffer, the preset clock buffer is the clock buffer 221. The clock buffer 221 is coupled to a portion of first computing array sub-circuits in the plurality of computing array sub-circuits, and the clock signal transmitter 23 is coupled to another portion of second computing array sub-circuits in the plurality of computing array sub-circuits. As shown, the second computing array sub-circuits to which the clock signal transmitter 23 is coupled comprise the computing the array sub-circuit 211 and the computing array sub-circuit 212, and the first computing array sub-circuits to which the clock buffer 221 is coupled may comprise the computing array sub-circuit 213, the computing array sub-circuit 214, ..., and the computing array sub-circuit 21m. In actual application, the numbers of the computing array sub-circuits to which the clock signal transmitter 23 and the clock buffer 221 are coupled may be the same or different, which may be specifically set according to the demands of the power consumption balance.

In some alternative embodiments, in a case where the at least one clock buffer comprises a plurality of clock buffers, for any first clock buffer 22i in the plurality of clock buffers, in response to the first clock buffer 22i being the preset clock buffer, the first clock buffer 22i is used to delay the input first clock signal CK1 for a specified duration and output a delayed clock signal CKOi; or, in response to the first clock buffer 22i not being the preset clock buffer, the first clock buffer 22i is used to delay a second clock signal CKOi-1 output by a second clock buffer 22i-1 cascaded before the first clock buffer 22i for a specified duration and output the delayed clock signal; the second clock signal CKOi-1 is the delayed clock signal output by the second clock buffer 22i-1.

The preset clock buffer may be a clock buffer physically located close to the clock signal transmitter 23 in the integrated circuit, such as the clock buffer 221 in the figure. For the case where the at least one clock buffer comprises a plurality of clock buffers, if the first clock buffer 22i is the preset clock buffer 221, i.e., i=1, then the clock signal input to the first clock buffer 221 is the first clock signal CK1, and the first clock buffer delays the CK1 for a specified duration and output the delayed clock signal CKO1. If the first clock buffer 22i is not the preset clock buffer 221, i.e., i is not 1, i=2, 3, ..., or m, then the second clock buffer cascaded before the first clock buffer before is the clock buffer 22i-1. The first clock buffer 22i delays the second clock signal output by the second clock buffer 22i-1 for a specified duration and output the delayed clock signal CKOi. As shown in FIG. 5, if the first clock buffer 22i is the clock buffer 222, the clock signal CKI2 input to the clock buffer 222 is the delayed clock signal CKO1 output by the clock buffer 221, the clock buffer 222 delays the second clock signal CKO1 output by the clock buffer 221 for a specified duration and outputs the delayed clock signal CKO2, the clock buffer 223 delays the CKO2 output by the clock buffer 222 for a specified duration and outputs the delayed clock signal CKO3, and so on. The clock buffers are connected in series, so that the delayed clock signals output by the clock buffers are not synchronized.

In some alternative embodiments, for a case where the plurality of clock buffers are connected in series, the values of the specified durations of the delays by the clock buffers may be the same or different. For example, in a case where the specified durations corresponding to the respective clock buffers are the same, if the number of clock buffers is n and the clock cycle of the first clock signal is T, the specified duration corresponding to each clock buffer may be T/n. That is, on the basis of the first clock signal CK1, the clock buffers connected in series successively delays the duration of T/n, namely, the first clock buffer 221 delays the first clock signal CK1 for T/n and outputs the delayed clock signal CKO1; the second clock buffer 222 delays the CKO2 for T/n again, and outputs the delayed clock signal CKO2, whereupon the delay duration of the CKO2 with respect to the first clock signal CK1 is 2T/n; and so on. Detailed description will not be presented any more. In a case where the specified durations corresponding to the respective clock buffers are different, it is feasible to ensure that the sum of the specified durations corresponding to the respective clock buffers is less than the clock cycle of the first clock signal CK1.

In alternative embodiments, in a case where n is greater than 1, the clock signal transmitter 23 may be coupled to at least one computing array sub-circuit, or the clock signal transmitter 23 may not be coupled to a computing array sub-circuit, which may be specifically set as actually needed, and not limited to the coupling relationship shown in FIG. 5. The transistors of the computing array sub-circuits may switch at n different dispersed times; for example, if n=2, a portion of computing array sub-circuits in all computing array sub-circuits acquire the delayed clock signal output by the first clock buffer, and another portion of computing array sub-circuits acquire the delayed clock signal output by the second clock buffer. Alternatively, the transistors of all the computing array sub-circuits may switch at n+1 different dispersed times, i.e., a portion of computing array sub-circuits in all the computing array sub-circuit acquire the first clock signal output by the clock signal transmitter, and the remaining computing array sub-circuits acquire the delayed clock signals output by the respective corresponding clock buffers. For example, if n=2, all the computing array sub-circuits may be divided into three portions (or groups), wherein the first portion of computing array sub-circuits acquire the first clock signal, the second portion of the computing array sub-circuits acquire the delayed clock signal output by the first clock buffer, and the third portion of computing array sub-circuit acquire the delayed clock signal output by the second clock buffer.

In some alternative embodiments, the number of the computing array sub-circuits to which each clock buffer is coupled may be set actually needed, and not limited in the embodiment of the present disclosure. The numbers of the computing array sub-circuits to which different clock buffers are coupled may be the same or different.

In the computing array integrated circuit provided in the present embodiment, it is possible to enable the transistors of the plurality of computing array sub-circuits to switch at two different dispersed times through the clock signal transmitter and the clock buffer, enable the transistors of the plurality of computing array sub-circuits to switch at a plurality of different dispersed times through a plurality of clock buffers connected in series, or enable the transistors of the plurality of computing array sub-circuits to switch at a plurality of different dispersed times through the clock signal transmitter and the plurality of clock buffers, thereby preventing a large number of transistors in the plurality of computing array sub-circuits from switching at the same time, improving the power consumption balance of the integrated circuit, and ensuring the safety of integrated circuit. In addition, for the plurality of clock buffers, the reduction of transmission lines of clock signals may also be facilitated by cascading the clock buffers.

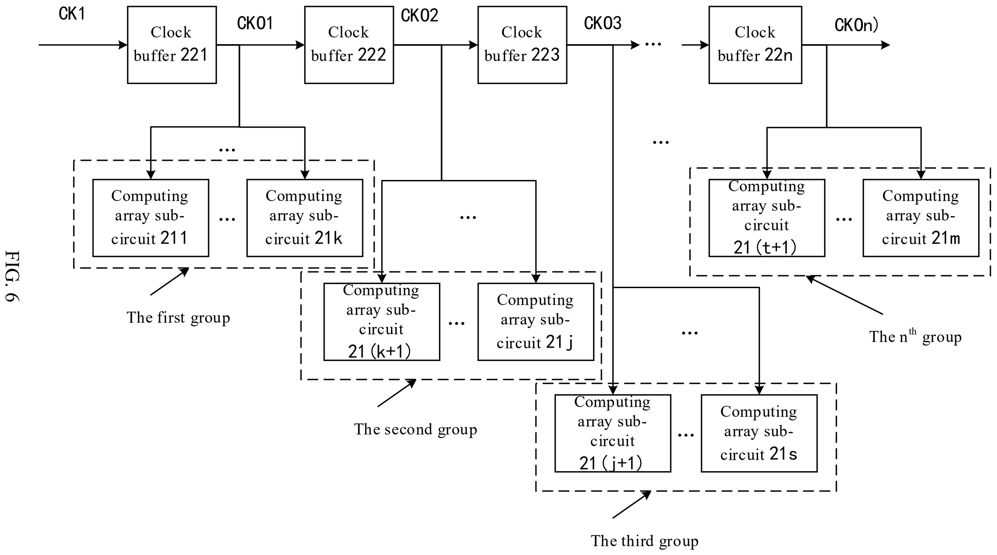

FIG. 6 is a schematic diagram of a computing array integrated circuit according to yet another exemplary embodiment of the present disclosure.

In some alternative embodiments, based on any of the embodiments described above, as shown in FIG. 6, the plurality of computing array sub-circuits 21 comprises a first number (denoted as m) of computing array sub-circuits; the at least one clock buffer 22 comprises a second number (denoted as n) of clock buffers; the second number n is less than or equal to the first number m.

The plurality of computing array sub-circuits 21 are determined as the second number of groups, each group including at least one computing array sub-circuit; each clock buffer is coupled to one of the groups of the computing array sub-circuits.

The first number m and the second number n may be set as actually needed. The manner of grouping the plurality of computing array sub-circuits 21 may be set according to a magnitude relationship between the second number n and the first number m, as well as the demands of power consumption balancing. For example, in a case where m is equal to n, each computing array sub-circuit is a group, i.e., each computing array sub-circuit corresponds to one clock buffer. In a case where n is less than m, the second number of groups may be determined in a uniform grouping manner or an approximately uniform grouping manner, e.g., if m is an integer multiple of n, each group may comprise m/n computing array sub-circuits, and each group corresponds to one clock buffer. If m is not an integer multiple of n, a portion of groups comprise floor(m/n) computing array sub-circuits, and another portion of groups comprise floor(m/n)+1 computing array sub-circuits, with floor( ) representing a rounding-down function. In actual application, the plurality of computing array sub-circuits 21 may also be determined as the second number of groups in other ways, not limited to the grouping manner in the above example. As shown in FIG. 6, the m computing array sub-circuits are determined into n groups, i.e., group 1, group 2, group 3, ..., and group n. The first group comprises k computing array sub-circuits ranging from the computing array sub-circuit 211 to the computing array sub-circuit 21k, k being greater than or equal to 1, the second group comprises j-k computing array sub-circuits ranging from the computing array sub-circuit 21(k+1) to the computing array sub-circuit 21j, j being greater than k, the third group comprises s-j computing array sub-circuits ranging from the computing array sub-circuit 21(j+1) to the computing array sub-circuit 21s, s being greater than j, ..., the n^{th} group comprises m-t computing array sub-circuits ranging from the computing array sub-circuit 21(t+1) to the computing array sub-circuit 21m, where t is greater than or equal to s, and t is less than m.

In some alternative embodiments, the plurality of computing array sub-circuits may comprise a plurality of rows and a plurality of columns of computing array sub-circuits, which are not limited to the arrangement manner of the computing array sub-circuits in the figure. For the plurality of rows and the plurality of columns of computing array sub-circuits, the plurality of computing array sub-circuits may be determined as the second number of groups according to the row-column relationship of the computing array sub-circuits. For example, the plurality of rows and columns may be divided by rows and columns, ensuring that the computing array sub-circuits in each group are sub-circuits in adjacent rows and/or columns. For example, if 48 computing array sub-circuits in 6 rows and 8 columns are determined as 8 groups, each column may be regarded as one group, or every three rows and every two columns may be regarded as a group, i.e., the computing array sub-circuits are divided into two portions as per rows with each portion including three rows, the computing array sub-circuits in the three rows in each portion are divided into four groups as per columns with the four portions including totally eight groups, to ensure that the computing array sub-circuits in each group are closer to their corresponding clock buffers, thereby reducing signal transmission paths.

It is to be appreciated that FIG. 6 only shows an example in which the plurality of clock buffers are connected in series, and that the present embodiment is also applicable to a scenario where the plurality of clock buffers are connected in parallel in practical application, not limited to the coupling relationship shown in FIG. 6.

In the embodiment of the present disclosure, the plurality of computing array sub-circuits are determined as the second number of groups, each group including one or more computing array sub-circuits, each clock buffer being coupled to a group of the computing array sub-circuits, thereby enabling the transistors of the plurality of computing array sub-circuits to switch at the second number of different dispersed times, and effectively reducing the dynamic power consumption of the integrated circuit.

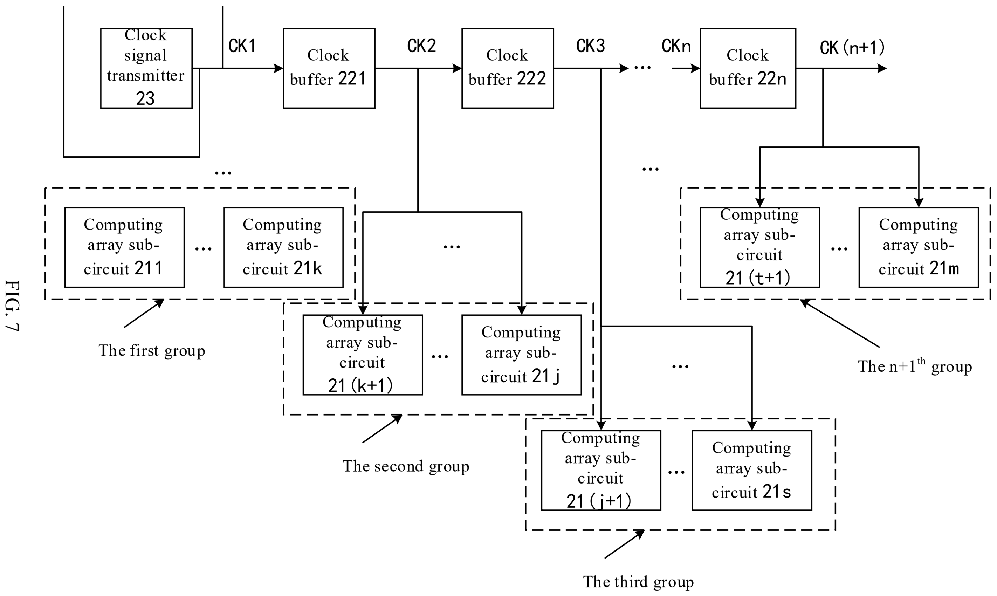

FIG. 7 is a schematic diagram of a computing array integrated circuit according to yet another exemplary embodiment of the present disclosure.

In some alternative embodiments, based on any of the above embodiments, as shown in FIG. 7, the plurality of computing array sub-circuits 21 may be determined as n+1 groups, each group including at least one computing array sub-circuit, wherein the computing array sub-circuits in one of the groups are coupled to the clock signal transmitter 23 to acquire the first clock signal CK1 from the clock signal transmitter 23, and the remaining n groups are respectively coupled to a clock buffer. As shown in FIG. 7, the first group acquires the first clock signal CK1, the second group is coupled to the clock buffer 221, the third group is coupled to the clock buffer 222, ..., and the n+1^{th} group is coupled to the clock buffer 22n. As compared with the integrated circuit shown in FIG. 6, one clock buffer may be reduced in the case where the groups are the same.

It is to be appreciated that FIG. 7 only shows an example in which the plurality of clock buffers are connected in series, and that the present embodiment is also applicable to a scenario where the plurality of clock buffers are connected in parallel in practical application, not limited to the coupling relationship shown in FIG. 7.

In some alternative embodiments, at least one clock buffer 22 comprises the second number of clock buffers; the values of the specified durations of the delays by the clock buffers are the same; the first clock cycle corresponding to the first clock signal CK1 is M times the specified duration corresponding to each clock buffer, M being the second number, i.e., n as described above.

The first clock cycle refers to a complete cycle of the first clock signal, and the first clock cycle may be determined according to the frequency of the first clock signal; for example, if the first clock signal is a clock signal of 1 GHZ, then the first clock cycle corresponding to the first clock signal is 1 nanosecond, and the specified duration corresponding to each clock buffer is 1/M, i.e., 1/n. On the basis that the clock buffers are cascaded (or series-connected), the specified duration corresponding to each clock buffer is determined on the principle that the first clock cycle corresponding to the clock signal CK1 is M times the specified duration of the delay by each clock buffer.

In the embodiment of the present disclosure, the specified duration corresponding to the clock buffer is determined based on the principle that the first clock cycle corresponding to the first clock signal is M times the specified duration corresponding to each clock buffer; on the one hand, this may ensure that the computing array sub-circuits are triggered to operate in the same clock cycle, to avoid an excessive delay; on the other hand, the transistors of the computing array sub-circuits are enabled to switch at different evenly-dispersed times within the clock cycle, thereby improving the balancing of dynamic power consumption of the integrated circuit, and effectively reducing the instantaneous dynamic power consumption of the integrated circuit.

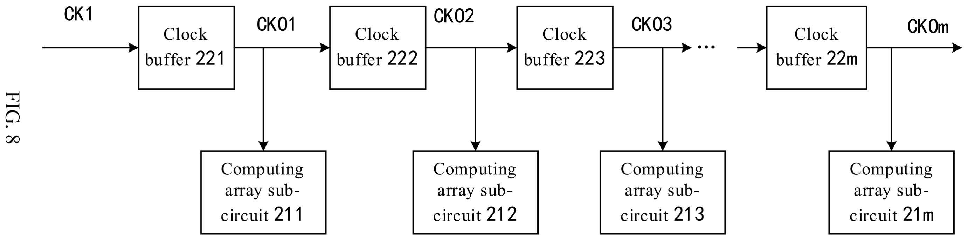

FIG. 8 is a schematic diagram of a computing array integrated circuit according to yet another exemplary embodiment of the present disclosure.

In some alternative embodiments, based on any of the embodiments described above, as shown in FIG. 8, the plurality of computing array sub-circuits 21 comprises a first number (denoted as m) of computing array sub-circuits; at least one clock buffer 22 comprises a first number (m) of clock buffers; each clock buffer is coupled to a computing array sub-circuit.

The clock buffers correspond one to one with the computing array sub-circuits, i.e., the clock buffer 221 is coupled to the computing array sub-circuit 211, and the computing array sub-circuit 211 acquires the delayed clock signal CKO1 output by the clock buffer 221; the clock buffer 222 is coupled to the computing array sub-circuit 212, and the computing array sub-circuit 212 acquires the delayed clock signal CKO2 output by the clock buffer 222; and so on, which will not be described in detail.

In the embodiment of the present disclosure, with the clock buffers corresponding one to one with the computing array sub-circuits, the transistors of the computing array sub-circuits are enabled to switch at different more-evenly-dispersed times, and the instantaneous dynamic power consumption of the integrated circuit is further reduced.

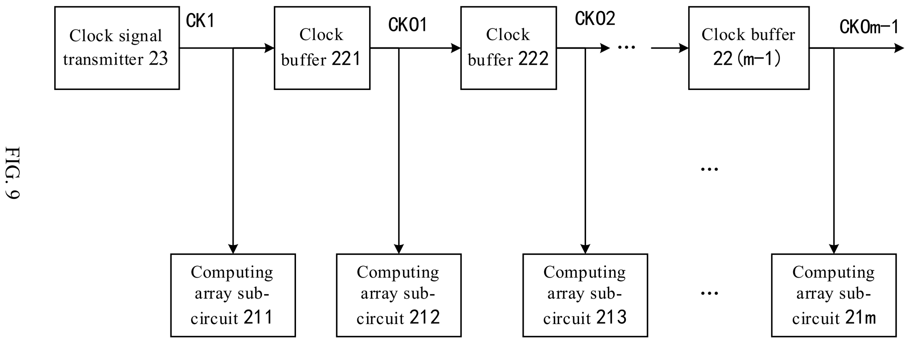

FIG. 9 is a schematic diagram of a computing array integrated circuit according to yet another exemplary embodiment of the present disclosure.

In some alternative embodiments, as shown in FIG. 9, the plurality of computing array sub-circuits 21 comprises m (m being an integer greater than 1) computing array sub-circuits; at least one clock buffer 22 comprises m-1 clock buffers; each clock buffer is coupled to a computing array sub-circuit, and the clock signal transmitter 23 is coupled to a computing array sub-circuit.

The number of the computing array sub-circuits is one more than the number of clock buffers, one computing array sub-circuit in the computing array sub-circuits acquires the first clock signal CK1 output by the clock signal transmitter 23, and the remaining m-1 computing array sub-circuits correspond one to one with the m-1 clock buffers; in a case where the number of computing array sub-circuits is determined, the present embodiment may reduce one clock buffer as compared with the structure shown in FIG. 8.

In some alternative embodiments, on the basis of any of the above-described embodiments, the values of the specified durations of the delays by the clock buffers are the same; the first clock cycle corresponding to the first clock signal is N times the specified duration corresponding to each clock buffer, and may be referred to as a constraint condition of the specified duration, N being a first number, namely, the above-described m. The integrated circuits shown in FIG. 8 and FIG. 9 may each determine a specified duration corresponding to each clock buffer based on the constraint condition of the specified duration of the present embodiment. For example, if the first clock cycle is T, the specified duration will be T/N (i.e., T/m).

In embodiments of the present disclosure, determining the specified duration corresponding to the clock buffer based on the number of the computing array sub-circuits and the clock cycle of the first clock signal ensures that each of the computing array sub-circuits can be triggered to operate within one clock cycle, thereby preventing an excessive delay from affecting the operation efficiency of the integrated circuit.

In some alternative embodiments, based on any of the embodiments described above, as shown in FIG. 2 and FIGS. 5-9, the at least one clock buffer comprises a plurality of clock buffers; the integrated circuit of the embodiment of the present disclosure further comprises: the clock signal transmitter 23.

The clock signal transmitter 23 is used for outputting the first clock signal CK1. The first clock buffer in the plurality of clock buffers is coupled to the clock signal transmitter, and the first clock buffer is used for delaying the input first clock signal CK1 for a specified duration and then outputting a delayed clock signal.

An output terminal of the i^{th} clock buffer is coupled to an input terminal of the (i+1)^{th} clock buffer; i= 1, 2, ..., or n -1, n being the number of clock buffers; the output terminal of the i^{th} clock buffer is further coupled to a computing array sub-circuit corresponding to the i^{th} clock buffer; the output terminal of the n^{th} clock buffer is coupled to the computing array sub-circuit corresponding to the n^{th} clock buffer.

The first clock buffer refers to the clock buffer at the initial position in a case where a plurality of clock buffers are cascaded. For example, in FIG. 2 or FIG. 5, the clock buffer 221 is the first clock buffer, the second clock buffer is the clock buffer 222, ... The clock signal input to the first clock buffer is the first clock signal CK1. The output terminal of the first clock buffer is coupled to the input terminal of the second clock buffer, the output terminal of the second clock buffer is coupled to the input terminal of the third clock buffer, and analogously, the output terminal of the (n-1)^{th} clock buffer is coupled to the input terminal of the n^{th} clock buffer, and the clock buffers are connected in series to realize multiple delays of the clock signal. The output terminal of each clock buffer is coupled to the computing array sub-circuit corresponding to the clock buffer. For example, in FIG. 5, the output terminal of the clock buffer 221 is coupled to the computing array sub-unit 213 corresponding to that clock buffer 221, ..., and the output terminal of the clock buffer 22n is coupled to the computing array sub-circuit 21m corresponding to that clock buffer 22n.

In embodiments of the present disclosure, the cascaded delays of clock signals are achieved by connecting the plurality of clock buffers in series, thereby enabling transistors of the plurality of computing array sub-circuits to switch at different dispersed times, thereby reducing instantaneous dynamic power consumption of the integrated circuit, and avoiding the instantaneous generation of the dynamic IR DROP.

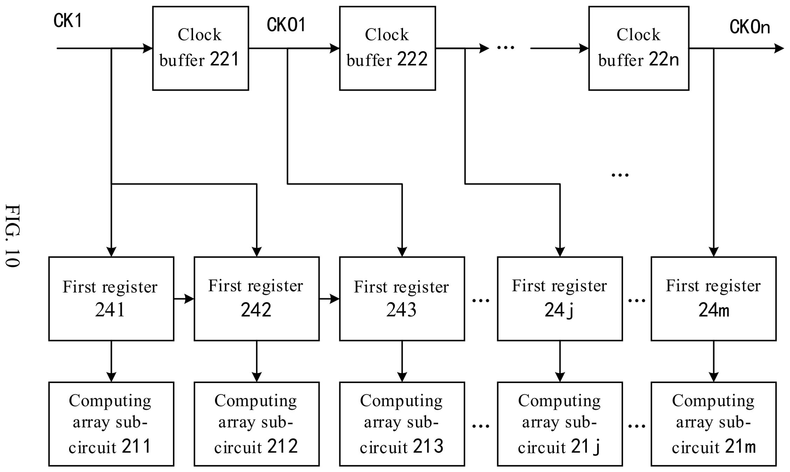

FIG. 10 is a schematic diagram of a computing array integrated circuit according to a further exemplary embodiment of the present disclosure.

In some alternative embodiments, based on any of the embodiments described above, as shown in FIG. 10, an integrated circuit of the embodiment of the present disclosure may further comprise:

a first register 24j respectively corresponding to each computing array sub-circuit 21j; j=1, 2, ..., or m, m being the number of the computing array sub-circuits.

The first register 24j is coupled to a clock buffer corresponding to the computing array sub-circuit 21j and is used to (or configured to) store data to be computed corresponding to the computing array sub-circuit.

The clock buffer 22i is used to delay the input clock signal for a specified duration and then output a delayed clock signal to the first register, where i=1, 2, . . ., or n, n being the number of the computing array sub-circuits.

The first register 24j may be any type of register, such as a general-purpose register, a shift register or the like, which may be specifically set as actually needed and limited to the embodiment of the present disclosure. The data to be computed corresponding to the computing array sub-circuit 21j is data needed in performing a computing task when the computing array sub-circuit operates. For example, if the computing array sub-circuit 21j is a sub-circuit for a convolution operation, the data to be computed may comprise at least one of feature data of the convolution operation and weight data of a convolution kernel. The delayed clock signal output by the clock buffer 22i is transmitted to the first register coupled to the clock buffer 22i. As shown in FIG. 10, the delayed clock signal CKO1 output by the clock buffer 221 is transmitted to the first register 243 of the computing array sub-circuit 213 to which the clock buffer 221 is coupled, to trigger the first register 243 to operate.

In some alternative embodiments, the delayed clock signal output by clock buffer 22i may be transmitted in parallel to the computing array sub-circuit corresponding to the clock buffer 22i and the first register corresponding to the computing array sub-circuit.

In an embodiment of the present disclosure, the integrated circuit comprises the first register corresponding to each computing array sub-circuit to facilitate the storage of data to be computed required for the operation of the computing array sub-circuit, and ensure that the computing array sub-circuit can operate normally.

In some alternative embodiments, the first register 24j is a shift register; as shown in FIG. 10, the first registers respectively corresponding to the computing array sub-circuits are coupled in a preset sequence;

Any one of the first registers 24j is used to (or is configured to) transmit the data in the first register 24j to another first register cascaded after with that first register by shifting.

As shown in FIG. 10, a first register 241, a first register 242, a first register 243, ..., and a first register 24m are sequentially connected in series; data in the first register 241 may be transmitted to the first register 242 cascaded after the first register 241 by shifting; data in the first register 242 may be transmitted to the first register 243 cascaded after the first register 242 by shifting; and so on, data may be transmitted between all the first registers by shifting. For example, when the computing array sub-circuits need to share some data, register shifting may be employed to reuse the shared data. Taking the convolution operation as an example, the weight data of the convolution kernel needs to participate in the weighted summation of different feature sub-data in the feature data; and the weight data of the convolution kernel may be respectively taken as the data to be computed of different computing array sub-circuits by register shifting, to realize the reuse of the data. Furthermore, taking matrix multiplication as an example, each row of the first matrix needs to respectively perform the multiply-add operation with each column of a second matrix, and the data of each row of the first matrix may be reused by register shifting.

In the embodiment of the present disclosure, the shift register is taken as the first register corresponding to the computing array sub-circuit, and the first registers are coupled in the preset sequence to form a data shift transmission path, so as to facilitate the reuse of data to be computed between the computing array sub-circuits.

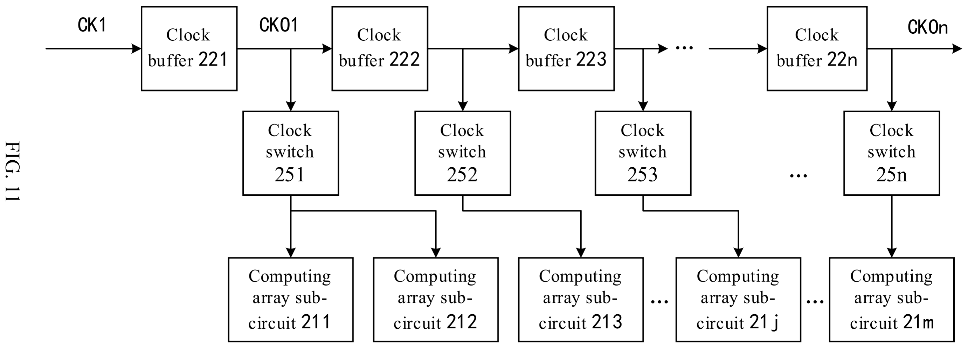

FIG. 11 is a schematic diagram of a computing array integrated circuit according to yet another exemplary embodiment of the present disclosure.

In some alternative embodiments, based on any of the above-described embodiments, the computing array integrated circuit of the embodiments of the present disclosure may further comprise: at least one clock switch 25. As shown in FIG. 11, an example is taken in which at least one clock switch 25 comprises n clock switches, i.e., a clock switch 251, a clock switch 252, ..., and a clock switch 25n.

Each clock switch 25i (i=1, 2, ..., or n) is connected in series to an output terminal of one clock buffer 22i of the at least one clock buffer 22;

The clock switch 25i is used to: in a case where the clock switch 25i is opened, cut off the delayed clock signal output by the clock buffer 22i connected to the clock switch 25i; or, in a case where the clock switch 25i is closed, communicate with the delayed clock signal output by the clock buffer 22i connected to the clock switch 25i, to transmit the delayed clock signal to the corresponding computing array sub-circuit.

The clock switch 25i is a gate for controlling ON/OFF of a clock signal transmission path. In the case where the clock switch is opened, the transmission path of the clock signal is in an OFF state, and the clock signal cannot be transmitted to the corresponding computing array sub-circuit; in the case where the clock switch is closed, the transmission path of the clock signal is in an ON state, and the clock signal can be transmitted to the corresponding computing array sub-circuit. Each clock switch 25i is connected in series to the output terminal of one clock buffer 22i, or in series to the input terminal of the computing array sub-circuit, to control whether the delayed clock signal output by that clock buffer is transmitted to the corresponding computing array sub-circuit. As shown in FIG. 11, the clock switch 251 is connected in series to the output terminal of the clock buffer 221 communicated to the computing array sub-circuit 211 and the computing array sub-circuit 212, to control whether the CKO1 is transmitted to the computing array sub-circuit 211 and the computing array sub-circuit 212.

In some alternative embodiments, any switch capable of controlling the ON/OFF of the signal transmission path may be employed as the clock switch, and is not limited in the embodiments of the present disclosure.

In the embodiments of the present disclosure, with the clock switches being provided, it is convenient to control the operation states of the computing array sub-circuits by controlling the opening/closing of the clock switches For example, when one or some of the computing array sub-circuits does not (do not) need to operate, it is possible to control the clock switches corresponding to the computing array sub-circuits to open to cut off the clock signals of the computing array sub-circuits, which helps to further reduce energy consumption; when some computing array sub-circuits need to operate, it is possible to control the clock switches corresponding to the computing array sub-circuits to close to communicate the clock signals of the computing array sub-circuits, thereby improving the flexibility of control of the integrated circuit in the application.

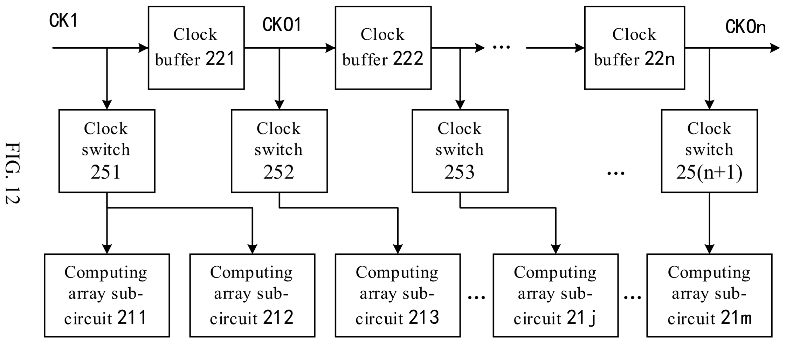

FIG. 12 is a schematic diagram of a computing array integrated circuit according to a further exemplary embodiment of the present disclosure.

In some alternative embodiments, as shown in FIG. 12, the number of clock switches may be n+1, where one clock switch (e.g., a clock switch 251) serves as the clock switch corresponding to the first clock signal CK1. The remaining n clock switches, i.e., a clock switch 252, a clock switch 253, ..., a clock switch 25(n+1), are respectively connected in series to the output terminal of a corresponding one of the clock buffers. For example, the clock switch 252 is connected in series to the output terminal of the clock buffer 221, the clock switch 253 is connected in series with the output terminal of the clock buffer 222, ... Reference may be made to the previous embodiment for the function of the clock switches. Detailed description will not be presented any more.

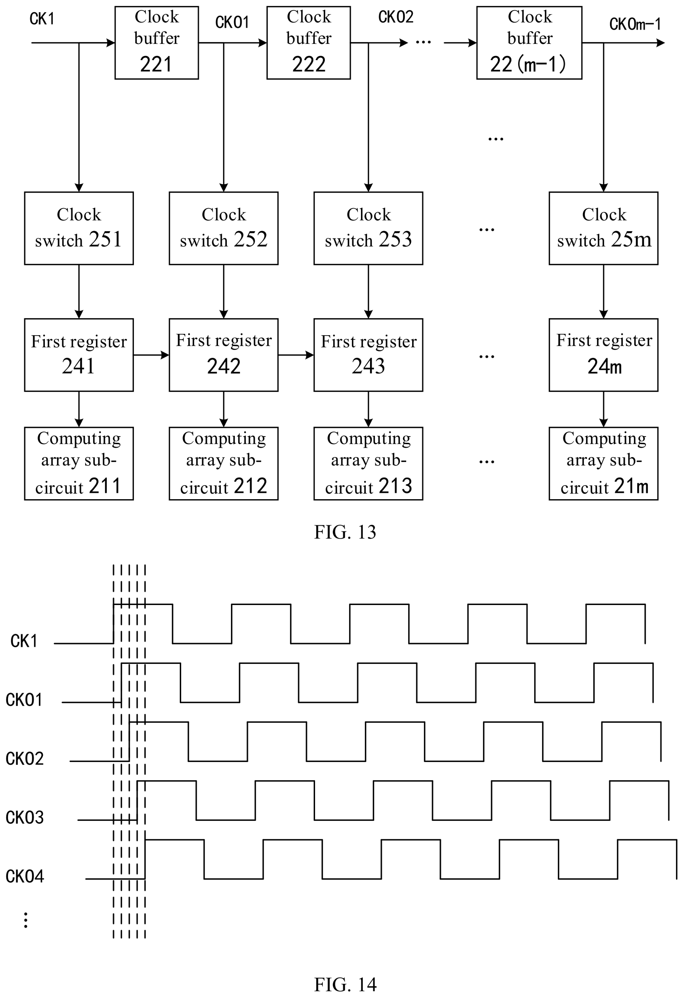

FIG. 13 is a schematic diagram of a computing array integrated circuit according to yet another exemplary embodiment of the present disclosure. As shown in FIG. 13, the computing array integrated circuit 20 of an embodiment of the present disclosure may comprise m computing array sub-circuits, first registers corresponding to the computing array sub-circuits respectively, m clock switches, and m-1 clock buffers. Specific functions of the components may be found in the foregoing embodiments and will not be described in detail herein.

In some alternative embodiments, each computing array sub-circuit may further comprise a second register for storing an intermediate computation result or a computation result upon completion of the computation during the operation of the computing array sub-circuit, and/or in a case where there is a data dependency between the computing array sub-circuits, the second register may store a computation result of the previously cascaded computing array sub-circuit. Alternatively, the second registers in the computing array sub-circuits may be shift registers electrically connected in a preset order, and data of the second register in one computing array sub-circuit is transmitted to the second register in another computing array sub-circuits by means of the shifting of the shift register, thereby implementing the transmission of the computation result of one computing array sub-circuit to another computing array sub-circuit, or implementing the reuse of the internal data of the computing array sub-circuit. The specific structures of the computing array sub-circuits are not limited.

FIG. 14 is a schematic diagram of clock signals according to an exemplary embodiment of the present disclosure. On the basis of the above-mentioned embodiments, as shown in FIG. 14, the first clock signal CK1 may be a clock signal from a preset clock source (namely, a clock signal transmitter), the first clock signal CK1 is taken as an undelayed clock signal, the clock buffer 221 delays the CK1 for a specified duration to obtain CKO1, the clock buffer 222 delays CKO1 for a specified duration again to obtain CKO2, and so on, so that the triggering edges of the clock signals are not synchronized. For example, for rising edges in FIG. 14, the transverse direction represents a time, longitudinal dashed lines represent times corresponding to the rising edges respectively, and a time interval between two adjacent dashed lines is the specified duration corresponding to the clock buffer, for example, the specified duration is 1/n of the first clock cycle of the CK1.

In the relevant art, each computing array sub-circuit is triggered to operate at the triggering edge of the first clock signal CK1, i.e., standard cells in the computing array sub-circuits simultaneously operate in a short period of time, and a large number of transistors switch simultaneously, thereby causing an excessive instantaneous power consumption, imposing an excessive pressure on the power supply of the integrated circuit, probably causing an excessive IR DROP, and causing functional errors to occur in the integrated circuit.

With regard to these problems in the relevant art, it can be seen based on the clock signals shown in FIG. 14 that in the computing array integrated circuit of the embodiment of the present disclosure, a plurality of non-synchronous clock signals with the same frequency are derived via the clock buffers, i.e., the delayed clock signals output by the clock buffers have the same frequency, but the triggering edges are not at the same time, there is a certain phase difference between the delayed clock signals output by the clock buffers, and the non-synchronous delayed clock signals output by the plurality of clock buffers are respectively transmitted to corresponding computing array sub-circuits, so that the computing array sub-circuits corresponding to different clock buffers are triggered to operate at the triggering edges at different times, thereby preventing all the computing array sub-circuits from being densely triggered to operate at the triggering edge of the same clock signal, effectively reducing the instantaneous power consumption of the integrated circuit, and avoiding the problem of the excessive IR DROP.

The above embodiments of the present disclosure may be implemented alone or in any combination without conflict, which may be specifically set as actually needed, and not be limited in the present disclosure.

### Exemplary Chips

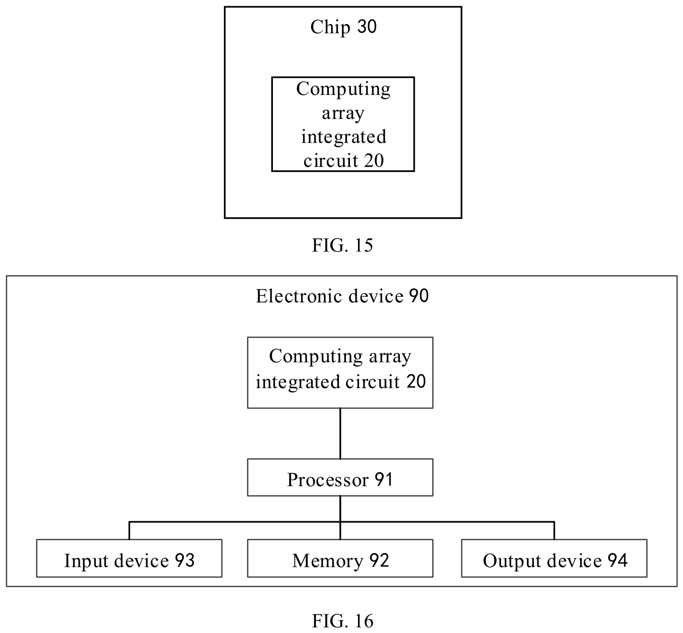

FIG. 15 is a schematic diagram of a chip according to an exemplary embodiment of the present disclosure. As shown in FIG. 15, a chip 30 according to an embodiment of the present disclosure may comprise: the computing array integrated circuit 20 according to any of the above embodiments.

In alternative embodiments, the chip 30 may further comprise components such as a processor, a memory, etc. The memory may store computer program instructions, and the processor may read and execute the computer program instructions stored in the memory to configure the computing array integrated circuit 20 and control the computing array integrated circuit 20 to perform corresponding computing tasks.

Advantageous effects corresponding to exemplary embodiments of the chip can be found from the corresponding advantageous effects of the above part Exemplary Method and will not be described in detail any more here.

### Exemplary Electronic Device

FIG. 16 illustrates a block diagram of an electronic device according to an embodiment of the present disclosure, including at least one processor 91 and a memory 92, and the computing array integrated circuit 20 according to any of the above embodiments of the present disclosure.

The processor 91 may be a Central Processing Unit (CPU) or another form of processing unit having a data processing capability and/or an instruction execution capability, and may control other components in the electronic device 90 to perform desired functions.

The memory 92 may comprise one or more computer program products. The computer program product may comprise various forms of computer-readable storage media, such as a volatile memory and/or a non-volatile memory. The volatile memory may comprise, for example, a Random Access Memory (RAM) and/or a cache. The non-volatile memory may comprise, for example, a Read-Only Memory (ROM), a hard disk, a flash memory or the like. The computer-readable storage medium may store one or more computer program instructions. The processor 91 may run one or more computer program instructions, to control the integrated circuits in the embodiments of the present disclosure to perform other desired functions.

In an example, the electronic device 90 may further comprise: an input device 93 and an output device 94. The components are interconnected through a bus system and/or other forms of connection mechanisms (not shown).

The input device 93 may further comprise, for example, a touch screen, a microphone, various sensors, etc. The sensors may comprise, for example, an image sensor (e.g., a camera, a video camera, etc.), a LIDAR, a millimeter wave radar, an ultrasonic radar, a positioning sensor, a pressure sensor, an air quality sensor, a temperature sensor, etc. The image sensor, the LIDAR, the millimeter wave radar, the ultrasonic radar, etc. man be used for sensing the surrounding environment, i.e., detect dynamic and static objects of the surrounding environment. The dynamic and static objects may include, for example, static objects such as lane lines, curbs, arrows, signs, trees and buildings, and dynamic objects such as surrounding vehicles, pedestrians, riders, etc. The positioning sensor is used to enable positioning of a mobile device (e.g., a self-propelled vehicle, robot, etc.) in which the electronic device is located. The positioning sensor may comprise, for example, an Inertial Measurement Unit (abbreviated as IMU), a Global Positioning System (abbreviated as GPS), etc. The pressure sensor may be used to detect a seat pressure. The temperature sensor may be used to detect a temperature in the vehicle cabin. The air quality sensor may be used to detect the quality of air in the vehicle cabin.

The output device 94 may output various information to the outside, and may comprise, for example, a display, a speaker, a communication network, and a remote output device connected thereto.

Certainly, for simplicity, only some of components in the electronic device 90 that are related to the present disclosure are shown in FIG. 16, and components such as a bus and an input/output interface are omitted. Besides, the electronic device 90 may further comprise any other appropriate components depending on specific application situations.

### Exemplary Computer Program Product and Computer Readable Storage Medium

In addition to the foregoing methods and devices, an embodiment of the present disclosure may further provide a computer program product, including computer program instructions. The computer program instructions, when executed by a processor, cause the processor to control the integrated circuit in the various embodiments of the present disclosure described in the foregoing part "Exemplary Circuit or Device" to perform desired functions.

The computer program product may be used to write, in any combination of one or more programming languages, program code for performing an operation in the embodiments of the present disclosure. The programming languages comprise object-oriented programming languages, such as Java and C++, and conventional procedural programming languages, such as "C" language or similar programming languages. The program code may be executed entirely on a user computing device, executed partly on user equipment, executed as a standalone software package, executed partly on a user computing device and partly on a remote computing device, or executed entirely on a remote computing device or a server.

In addition, the embodiment of the present disclosure may alternatively be a computer-readable storage medium, storing computer program instructions. The computer program instructions, when executed by a processor, cause the processor to control the integrated circuit in the various embodiments of the present disclosure described in the foregoing part "Exemplary Circuit or Device" to perform desired functions

The computer-readable storage medium may be any combination of one or more readable media. The readable medium may be a readable signal medium or a readable storage medium. The readable storage medium may comprise, for example, but not limited to electrical, magnetic, optical, electromagnetic, infrared, or semiconductor systems, apparatuses, or devices, or any combination thereof. More specific examples (non-exhaustive list) of the readable storage medium comprise: an electrical connection with one or more conducting wires, a portable disk, a hard disk, a Random Access Memory (RAM), a Read-only Memory (ROM), an Erasable Programmable Read-Only Memory (EPROM or flash memory), an optical fiber, a portable Compact Disc Read-Only Memory (CD-ROM), an optical memory device, a magnetic memory device, or any suitable combination thereof.

The basic principles of the present disclosure have been described above with reference to specific embodiments. However, it should be noted that the benefits, advantages, effects, and the like mentioned in the present disclosure are only examples rather than limitations, and these benefits, advantages, effects, and the like should not be considered to be necessary for the embodiments of the present disclosure. Moreover, the specific details disclosed above are for exemplary purposes and ease of understanding only, but not for limitation, and the above details do not limit the present disclosure to be implemented by using the specific details described above.

Those skilled in the art can make various variations and modifications to the present disclosure without departing from the spirit and scope of the present disclosure. As such, if these variations and modifications to the present disclosure fall within the scope of claims of the present disclosure and equivalent technologies, the present disclosure is also intended to comprise these variations and modifications.

## Claims

1. A computing array integrated circuit, comprising:
at least one clock buffer for delaying an input clock signal for a specified duration and outputting the delayed clock signal, the delayed clock signals output by the different clock buffers not being synchronized;
a plurality of computing array sub-circuits, each of the clock buffers being coupled to at least one computing array sub-circuit in the plurality of computing array sub-circuits, each of the computing array sub-circuits acquiring the delayed clock signal output by the respective corresponding clock buffer.

2. The integrated circuit according to claim 1, wherein the at least one clock buffer comprises a plurality of clock buffers, and the integrated circuit further comprises:
a clock signal transmitter for outputting a first clock signal;
wherein any one clock buffer in the plurality of clock buffers is used for delaying the input first clock signal for a specified duration and outputting the delayed clock signal, values of the specified durations of delays by different clock buffers being different.

3. The integrated circuit according to claim 1 or 2, wherein the integrated circuit further comprises:
a clock signal transmitter for outputting a first clock signal;
wherein in a case where the at least one clock buffer comprises only one clock buffer, the clock buffer is used to delay the input first clock signal for a specified duration and output the delayed clock signal, the clock buffer is coupled to a first computing array sub-circuit in the plurality of computing array sub-circuits, the clock signal transmitter is coupled to a second computing array sub-circuit in the plurality of computing array sub-circuits, and the second computing array sub-circuit is a computing array sub-circuit in the plurality of computing array sub-circuits other than the first computing array sub-circuit; or
in a case where the at least one clock buffer comprises a plurality of clock buffers, for any first clock buffer in the plurality of clock buffers, in response to the first clock buffer being a preset clock buffer, the first clock buffer is used to delay the input first clock signal for a specified duration and output the delayed clock signal; or, in response to the first clock buffer not being the preset clock buffer, the first clock buffer is used to delay a second clock signal output by a second clock buffer cascaded before the first clock buffer for a specified duration and output the delayed clock signal; the second clock signal is the delayed clock signal output by the second clock buffer.

4. The integrated circuit according to any one of the preceding claims, wherein the plurality of computing array sub-circuits comprise a first number of computing array sub-circuits;
the at least one clock buffer comprises a second number of clock buffers; the second number is less than or equal to the first number;
the plurality of computing array sub-circuits are determined as the second number of groups, each group including at least one of the computing array sub-circuits; each of the clock buffers is coupled to one of the groups of the computing array sub-circuits.

5. The integrated circuit according to claim 3 or 4, wherein the at least one clock buffer comprises the second number of clock buffers; values of the specified durations of the delays by the clock buffers are the same; a first clock cycle corresponding to the first clock signal is M times the specified duration corresponding to each of the clock buffers, M being the second number.

6. The integrated circuit according to claim 3, wherein the plurality of computing array sub-circuits comprise a first number of computing array sub-circuits;
the at least one clock buffer comprises the first number of said clock buffers;
each of the clock buffers is coupled to one of the compute array sub-circuits.

7. The integrated circuit according to claim 6, wherein values of the specified durations of the delays by the clock buffers are the same; a first clock cycle corresponding to the first clock signal is N times the specified duration corresponding to each of the clock buffers, N being the first number.

8. The integrated circuit according to any one of the preceding claims, wherein the at least one clock buffer comprises a plurality of clock buffers; the integrated circuit further comprises:
a clock signal transmitter for outputting a first clock signal;
wherein a first clock buffer of the plurality of clock buffers is coupled to the clock signal transmitter, and the first clock buffer is used for delaying the input first clock signal for a specified duration and outputting the delayed clock signal;
an output terminal of the i^{th} clock buffer is coupled to an input terminal of the (i +1)^{th} clock buffer; i= 1, 2, ..., or n-1, n being the number of clock buffers;
an output terminal of the i^{th} clock buffer is further coupled to the computing array sub-circuit corresponding to the i^{th} clock buffer;
an output terminal of the n^{th} clock buffer is coupled to the computing array sub-circuit corresponding to the n^{th} clock buffer.

9. The integrated circuit according to any one of the preceding claims, further comprising:
first registers respectively corresponding to the computing array sub-circuits;
wherein the first registers are coupled to the clock buffers corresponding to the computing array sub-circuits and are configured to store data to be computed corresponding to the computing array sub-circuits;
the clock buffers are used for delaying the input clock signals for a specified duration and then outputting the delayed clock signals to the first registers.

10. The integrated circuit according to claim 9, wherein the first registers are shift registers; the first registers respectively corresponding to the computing array sub-circuits are coupled in a preset sequence;
any one of the first registers is used for transmitting data in the first register to another first register cascaded after the first register by shifting.

11. The integrated circuit according to any of claims 1-10, further comprising:
at least one clock switch;
wherein each of the clock switches is connected in series to an output terminal of one of the at least one clock buffer;
the clock switch is configured to:
in a case where the clock switch is opened, cut off the delayed clock signal output by the clock buffer connected to the clock switch; or,
in a case where the clock switch is closed, communicate the delayed clock signal output by the clock buffer connected to the clock switch, to transmit the delayed clock signal to the corresponding computing array sub-circuit.

12. A chip, comprising:
the computing array integrated circuit according to any of claims 1-11.
